Europäisches Patentamt

European Patent Office

Office européen des brevets

(11) Publication number: **0 416 589 A2**

# EUROPEAN PATENT APPLICATION

(21) Application number: 90117115.7

(22) Date of filing: 05.09.90

(51) Int. Cl.⁵: **G01R 31/36**

(30) Priority: 08.09.89 JP 233421/89

(43) Date of publication of application:
**13.03.91 Bulletin 91/11**

(84) Designated Contracting States:
**DE FR GB**

(71) Applicant: **KABUSHIKI KAISHA TOSHIBA**
**72, Horikawa-cho Saiwai-ku**
**Kawasaki-shi Kanagawa-ken 210(JP)**

(72) Inventor: **Iizuka, Emiko, c/o Intellectual**
**Property Div.**
**Kabushiki Kaisha Toshiba, 1-1 Shibaura**
**1-chome**
**Minato-ku, Tokyo 105(JP)**

(74) Representative: **Henkel, Feiler, Hänzel &**
**Partner**
**Möhlstrasse 37**
**W-8000 München 80(DE)**

(54) Computer having a function of detecting a low-battery state.

(57) A battery (12) is used as a power source for a computer apparatus. A reference voltage for determining a low-battery state of the battery is set in consideration of not only the current value of a current output from the battery but also the temperature of the battery. An output voltage from the battery (12) is compared with the reference voltage, thereby determining whether or not the battery is in the low-battery state.

F I G. 2

termined by the value of current of a battery and sthe temperature of the battery;

Fig. 8 is a flowchart for illustrating the operation of a power CPU according to a second embodiment of the invention;

Fig. 9 is a graph showing an example of a characteristic curve selected on the basis of the value of current of a battery and the temperature of the battery; and

Fig. 10 is a flowchart for illustrating the operation of a power CPU according to a third embodiment of the invention.

Preferred embodiments of the present invention will now be described in detail with reference to the accompanying drawings.

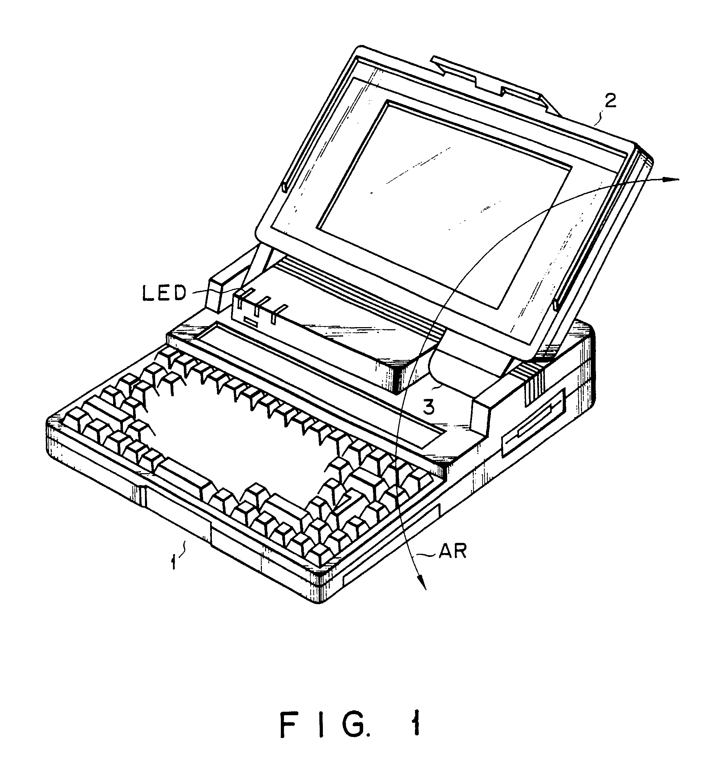

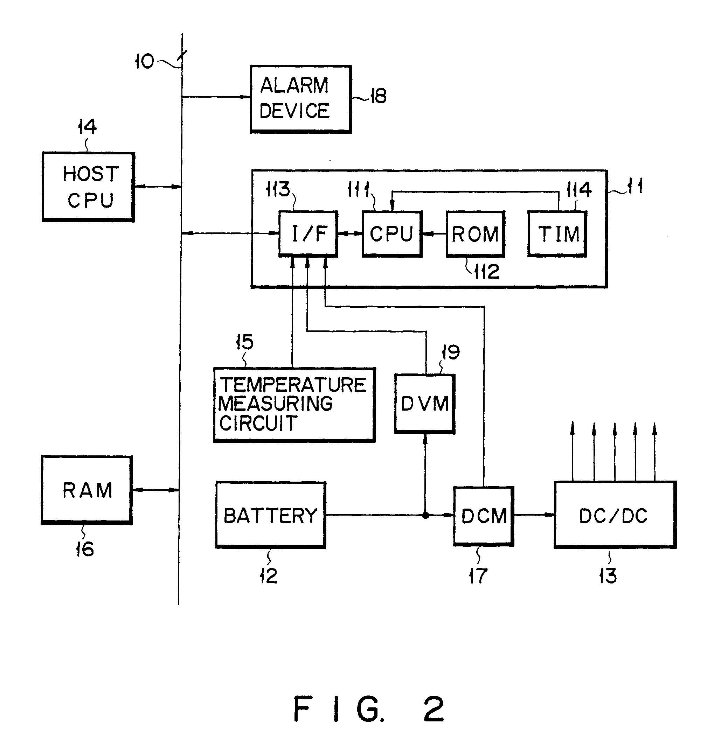

Fig. 2 is a block diagram showing a structure of a computer according to a first embodiment of the invention.

In Fig. 2, a bus 10 is connected to a power controller 11, a host CPU 14, a RAM 16, and an alarm device 18.

The output from a battery 12 is supplied to a DC/DC converter through a DC amperemeter 17, and to a voltmeter 19.

The outputs from a temperature measuring circuit 15, the amperemeter 17 and the voltmeter 19 are supplied to the power controller 11.

The bus 10 functions for data transmission. The host CPU 14 is operated in accordance with a program stored in the RAM 16, thereby controlling the entire operation of the computer.

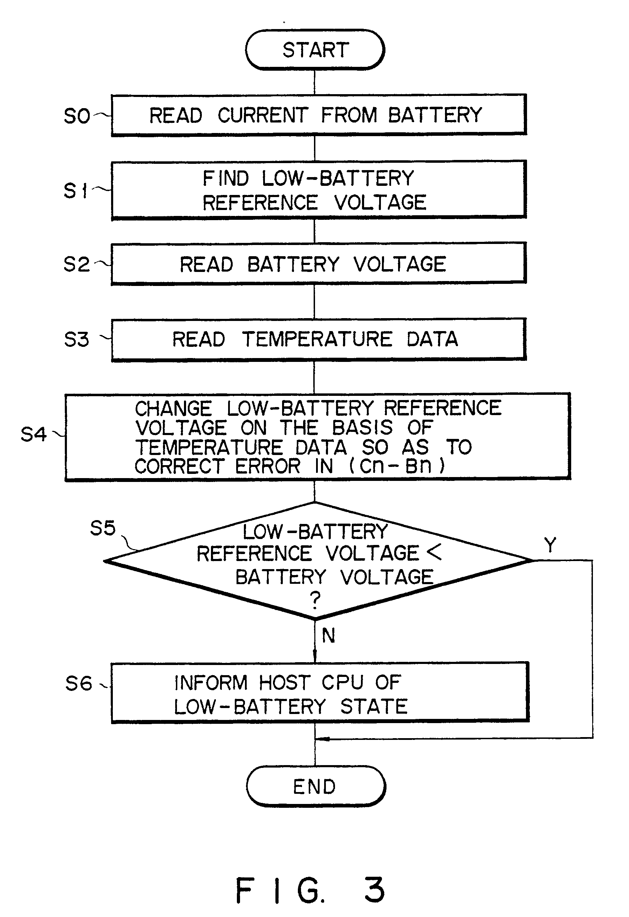

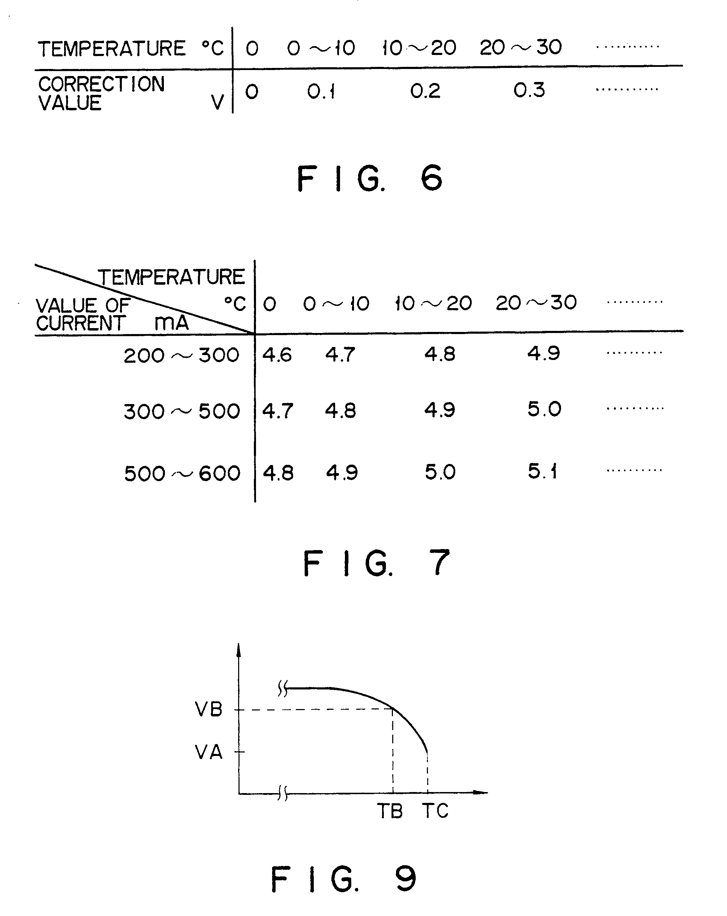

The power controller 11 includes, for example, a power CPU 111, a ROM 112, an interface 113, and a timer 114. The power controller 11 itself has intelligence. The power CPU 111 is operated according to a program stored in the ROM 112, as is illustrated in Fig. 3. ROM 112 stores, for example, a program for carrying out the processing illustrated in Fig. 3, correction values shown in Fig. 6, etc. The interface 113 controls transmission of signals between the host CPU 14 and the power CPU 111, transfer of data from an external device to the power CPU 111, etc. The timer 114 outputs interrupt signals to the power CPU 111 at predetermined time intervals.

The power controller 11 receives the output voltage from the battery 12, the detection data from the temperature measuring circuit 15, and the detected values from the amperemeter 17. Based on them, the controller 11 carries out a predetermined low-battery detection processing. In addition, the power controller 11 has a general function of a power controller, for example, a function of charging the battery 12 when power is supplied from an external power supply.

The temperature measuring circuit 15 comprises, for example, a thermistor connected to the battery 12, a circuit for detecting the resistance of the thermistor, etc. The temperature measuring circuit 15 measures the temperature of the battery 12, and supplies the obtained temperature data to the power controller 11.

The RAM 16 stores an operation program for the host CPU 14.

The DC/DC converter 13 converts a DC power from the battery 12 to a predetermined voltages and supplies the obtained voltage to predetermined parts. For example, the DC/DC converter 13 supplies 24 V to a display (not shown) and 5 V to a semiconductor device such as a CPU.

The DC amperemeter 17 detects the value of the current supplied from the battery 12 to the DC/DC converter 13, and supplies the detected value to the power controller 11.

The operation for low-battery state detection according to this embodiment will now be described in detail. For the purpose of easier understanding, it is supposed that the system shown in Fig. 2 is designed such that the minimum value of the output current from sthe battery during operation of the system is 200 mA, the maximum output current thereof is 600 mA, the lowest temperature of the battery is $0°C$, and the highest temperature thereof is $60C°$.

The timer 114 in the power controller 11 outputs interrupt signals to the power CPU 111 at predetermined time intervals, e.g. 1 second. Responding to the interrupt signal, the power CPU 11 reads out a program from the internal ROM 112 and executes the low-battery detection processing illustrated in Fig. 3.

First, the power CPU 111 takes in data from the amperemeter 17 and finds the value of current from the battery 12 (step 50). The power CPU 111 approximates the obtained current value to any one of 600 mA, 400 mA and 200 mA. For example, when the current value is 450 mA, the power CPU 111 approximates the current value to 400 mA.

Subsequently, the power CPU 111 reads out a low-battery reference voltage which is stored in the ROM 112 for each of various current values (step S1).

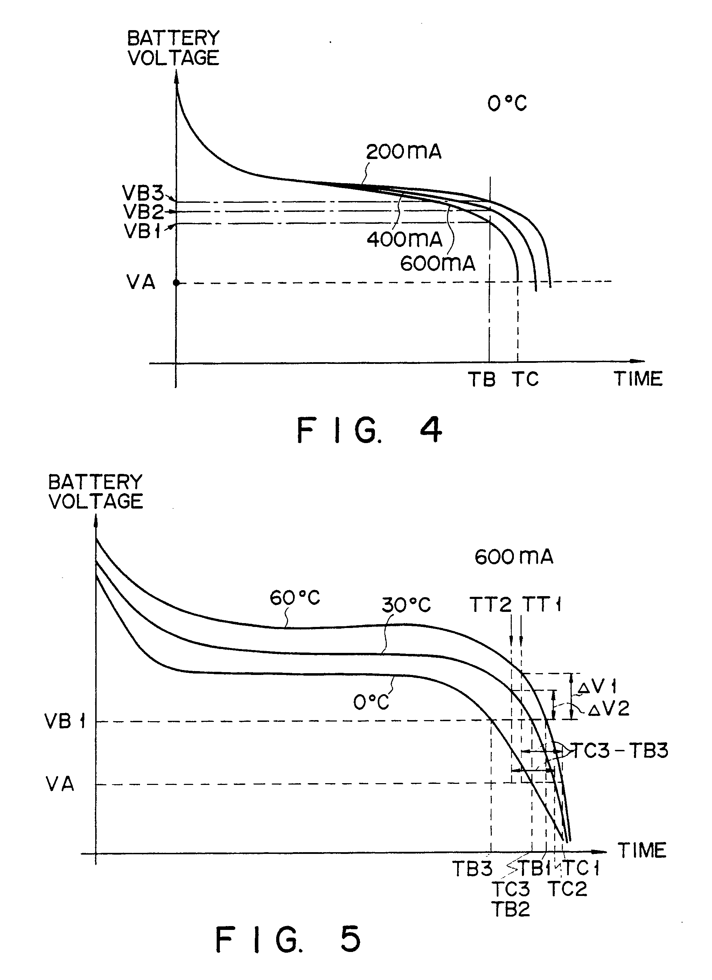

The process of setting the low-battery reference voltage will now be described specifically with reference to Fig. 4. Three curves shown in the graph of Fig. 4 indicate variations of battery voltage, with the passage of time, when the values of currents from the battery are 200 mA, 400 mA, and 600 mA, and the battery temperature is a reference value ($0°C$). In Fig. 4, value VA indicates a minimum battery voltage, below which the computer may not normally function.

When the maximum current, i.e. 600 mA, used in this computer is employed, the battery voltage reaches VA at a time TC. Time TB precedes time TC by a predetermined time period, for example,

In the above embodiment, reference voltages are obtained when the current values are 200, 400, and 600 mA. These current values are variable in accordance with the structure of the system and the design specifications. The number of current values is not limited to three. Reference voltages may be obtained for four or more current values.

In the above embodiment, when an actual output current of the battery is not 200, 400, or 600 mA, it is approximated to any one of these values. For example, when the measured output current of the battery is 450 mA, it is approximated to 400 mA. However, the reference voltage may be found more precisely, for example, by an interpolation process. For example, in Fig. 4, when the current value is 500 mA, the reference voltage can be found to be (VB2 + VB3)/2 by a direct interpolation method.

According to the above embodiment, the reference voltage is obtained when the temperature of the battery is 0°C, and this reference value is corrected. Thus, a positive correction value is added to the reference value. This invention, however, is not limited to this method. For example, the reference voltage is found when the temperature of the battery is highest. In this case, a large correction value is subtracted from the reference value as the temperature becomes lower.

In addition, in the above embodiment, the correction values are constant for specific temperatures, irrespective of the difference in current value. It is possible to obtain the correction value for each current value, thereby to correct the reference voltage.

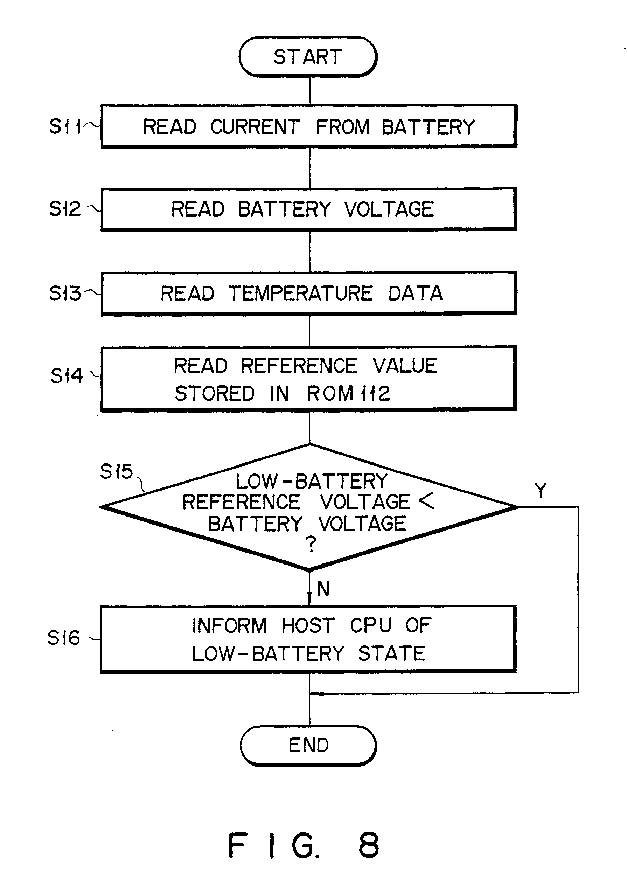

A second embodiment of the present invention will now be described with reference to Figs. 7 and 8.

According to the second embodiment, corrected reference voltages are obtained directly from the aforementioned output current and temperature of the battery.

In this embodiment, the reference voltage is obtained for each pair of the corresponding temperature and current value, by experiments or computer simulation, so that the time period TCn-TBn may be kept substantially constant. As is shown in Fig. 7, the obtained reference voltages are stored in the ROM 112 in advance.

Upon receiving an interrupt signal from the timer 114, the power CPU 111 starts the processing illustrated in Fig. 8. The power CPU 111 reads the output current of the battery, the output voltage of the battery, and the temperature of the battery (steps S11 to S13).

In step S14, the power CPU 111 directly finds the reference voltage stored in the ROM 112, as shown in Fig. 7, on the basis of the read output current and temperature. For example, when the measured current is 350 mA and the temperature is 15°C, the reference voltage is 4.9 V. The obtained reference voltage is compared with the battery voltage (step S15), and the processing according to the comparison result is carried out (step S16).

In the second embodiment, too, the low-battery state can be detected exactly.

A third embodiment of the present invention will now be described.

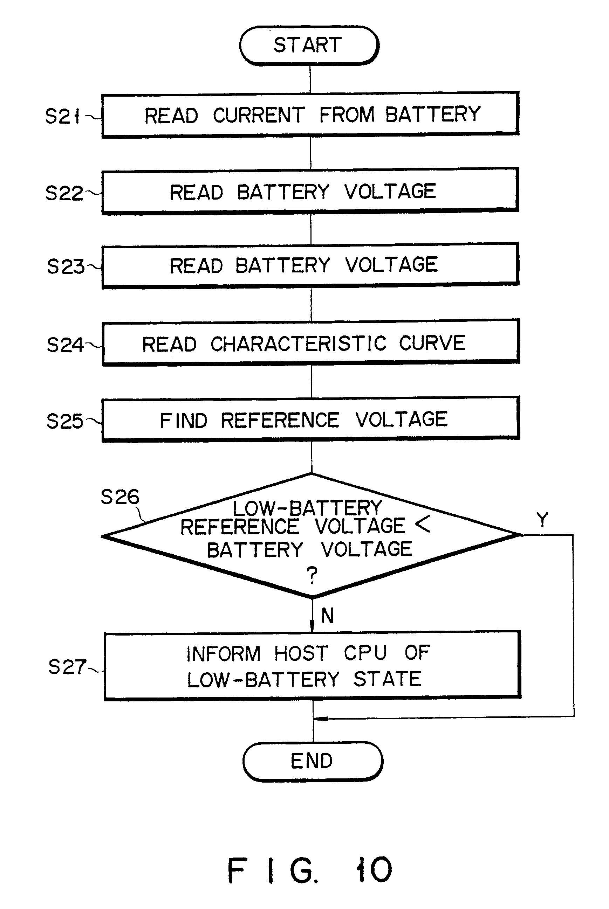

In the third embodiment, a characteristic curve (only a portion near voltage VA is sufficient), shown in Fig. 9, is stored in advance in the ROM 112 in the form of a function or a graph, for each pair of the corresponding temperature and current value.

Upon receiving an interrupt signal from the timer 114, the power CPU 111 starts the processing illustrated in Fig. 10. The power CPU 111 reads successively the output current of the battery, the output voltage of the battery, and the temperature of the battery (steps S21 to S23). One of the characteristic curves stored in ROM 112 is selected on the basis of the read temperature and current value (step S24).

Subsequently, the power CPU 111 finds time TC on the basis of the selected curve and the predetermined voltage VA. A predetermined time period is subtracted from the time TC to find time TB. Based on time TB, a reference voltage is obtained (step S25). The obtained reference voltage is compared with the battery voltage (step S26). The processing according to the comparison result is carried out (step S27).

In the above embodiments, the output current of the battery and the battery temperature are employed as factors for determining the reference voltage; however, the charge time of the battery, the rate of decrease on the basis of the actually measured output voltage of the battery, etc. may also be employed as such factors.

The present invention is not limited to the above embodiments, and various modifications may be made within the scope of the subject matter of the invention.

## Claims

1. An apparatus for determining whether or not a battery is in a low-battery state, in consideration of temperature, said apparatus comprising:
current value detecting means (17) for detecting the value of current output from the battery;
temperature detecting means (15) for detecting temperature;
reference voltage setting means (111) for setting a reference voltage on the basis of the value of current detected by said current value detecting

means (111) for reading out the correction voltage from the memory means (112) in response to the detected temperature, and means (111) for correcting the reference voltage in accordance with the read-out correction voltage.

16. The apparatus according to claim 9, characterized in that said reference voltage setting means includes memory means (112) for storing the reference voltage predetermined in accordance with the temperature and output current of the battery, and means (111) for selectively reading out the reference voltage from the memory means (112) in accordance with the detected temperature and the output current from the battery.

17. The apparatus according to claim 9, characterized in that said computer apparatus is a portable computer.

18. A method of determining whether or not a battery is in a low-battery state, in consideration of temperature, said method comprising:

a current value detecting step (17) for detecting the current value of a current output from the battery;

a temperature detecting step (15) of detecting the temperature;

a reference voltage setting step (111) of setting a reference voltage in accordance with the detected current value and temperature; and

a comparing step (111) of comparing an output voltage from the battery (12) with the reference voltage.

19. The method according to claim 18, characterized in that said reference voltage setting step comprises:

a step of finding a first point in time (TC) at which a characteristic curve representing a variation of a battery voltage with the passage of time, when temperature is a predetermined degree ($0^{\circ}$ C) and a current has a predetermined value (600 mA), reaches a predetermined operation enable voltage value (VA);

a step of finding a second point in time (TB) which precedes the first point in time (TC) by a predetermined time;

a step of finding reference voltages (VB2, VB3) for desired output currents (200, 400 mA), on the basis of battery voltages (VB2, VB3) given by characteristic curves for the desired output currents (200, 400 mA) at the second point in time (TB) at the predetermined temperature ($0^{\circ}$ C); and

a correction step (11) of correcting the found reference voltages (VB2, VB3) in accordance with the temperature, thereby obtaining final reference voltages.

20. The method according to claim 19, characterized in that said correcting step comprises:

a step of finding a third point in time (TCn) at which the characteristic curve of the battery, which corresponds to the predetermined output voltage (600 mA) and a desired temperature, reaches a the predetermined operation enable voltage value (VA);

a step of determining a fourth point in time (TTn) which precedes the third point in time (TC) by said predetermined time;

a step of finding a voltage defined by said characteristic curve at the fourth point in time;

a step of finding a difference between said found voltage and said reference voltage for each of specific temperatures; and

a step of adding said difference in voltage to said reference voltage, on the basis of detected temperature and current value.

LED

2

3

AR

1

F I G. 1

F I G. 2

START

SO READ CURRENT FROM BATTERY

S1 FIND LOW-BATTERY REFERENCE VOLTAGE

S2 READ BATTERY VOLTAGE

S3 READ TEMPERATURE DATA

S4 CHANGE LOW-BATTERY REFERENCE VOLTAGE ON THE BASIS OF TEMPERATURE DATA SO AS TO CORRECT ERROR IN ( Cn - Bn )

S5 LOW-BATTERY REFERENCE VOLTAGE < BATTERY VOLTAGE ? — Y

N

S6 INFORM HOST CPU OF LOW-BATTERY STATE

END

F I G. 3

BATTERY
VOLTAGE

0°C

200mA

VB3
VB2
VB1

400mA

600mA

VA

TB TC            TIME

F I G. 4

BATTERY
VOLTAGE

600 mA

60°C        30°C        TT2 TT1

0°C                              ΔV1
                                   ΔV2

VB1

                              TC3 - TB3

VA

                                   TIME

TB3  TB1 TC1
     TC3 TC2
     TB2

F I G. 5

11

| TEMPERATURE °C | 0 | 0~10 | 10~20 | 20~30 | ........... |
|---|---|---|---|---|---|
| CORRECTION VALUE V | 0 | 0.1 | 0.2 | 0.3 | ........... |

# F I G.  6

| VALUE OF CURRENT mA \ TEMPERATURE °C | 0 | 0~10 | 10~20 | 20~30 | ........... |
|---|---|---|---|---|---|
| 200~300 | 4.6 | 4.7 | 4.8 | 4.9 | ........... |
| 300~500 | 4.7 | 4.8 | 4.9 | 5.0 | ........... |
| 500~600 | 4.8 | 4.9 | 5.0 | 5.1 | ........... |

# F I G.  7

# F I G.  9

START

S11 — READ CURRENT FROM BATTERY

S12 — READ BATTERY VOLTAGE

S13 — READ TEMPERATURE DATA

S14 — READ REFERENCE VALUE STORED IN ROM 112

S15 — LOW-BATTERY REFERENCE VOLTAGE < BATTERY VOLTAGE ? — Y

N

S16 — INFORM HOST CPU OF LOW-BATTERY STATE

END

F I G.  8

START

S21 — READ CURRENT FROM BATTERY

S22 — READ BATTERY VOLTAGE

S23 — READ BATTERY VOLTAGE

S24 — READ CHARACTERISTIC CURVE

S25 — FIND REFERENCE VOLTAGE

S26 — LOW-BATTERY REFERENCE VOLTAGE < BATTERY VOLTAGE ? —— Y

N

S27 — INFORM HOST CPU OF LOW-BATTERY STATE

END

F I G. 10